# EUROPEAN PATENT APPLICATION

(11) **EP 4 686 332 A1**
(43) Date of publication of application: **28.01.2026**
(21) Application number: 25192004.7
(22) Date of filing: 25.07.2025
(51) Int. Cl.: H05K 7/20

(54) **SENSOR AGGREGATION WITH WIRELESS SENSORS**

(30) Priority: 26.07.2024 US 202463676082 P
(71) Applicant: Vertiv Corporation, Westerville, OH 43082 (US)
(72) Inventor: HARDYBALA, Philip Michael, Westerville, 43082 (US); SPATZ, Mark Andrew, Westerville, 43082 (US); VOIGT, Tyler William, Westerville, 43082 (US); MCCONNELL, John Lawrence, Westerville, 43082 (US)
(74) Representative: Bryn-Jacobsen, Caelia

(57) **Abstract**

A cooling system can include a cooling unit for supplying cooling air, one or more enclosures that receive the cooling air, a cooling air supply path for routing the cooling air from the cooling unit to the enclosure, a return air path for routing the cooling air from the enclosure to the cooling unit, one or more wired temperature sensors disposed in the cooling air supply path and wired to the cooling unit, one or more wireless temperature sensors disposed in the cooling air supply path and in wireless communication with the cooling unit, and one or more wireless temperature sensors disposed in the return air path and in wireless communication with the cooling unit. The cooling unit can utilize data from any combination of the wired temperature sensors and the wireless temperature sensors for supplying the cooling air.

## Description

### CROSS REFERENCE TO RELATED APPLICATIONS

This application claims the benefit of U.S. Provisional Patent Application No. 63/676,082 filed July 26, 2024.

### TECHNICAL FIELD

The present disclosure relates generally to cooling systems, such as those used in data centers, and more specifically relates to sensor arrangements for cooling systems.

### BACKGROUND

Equipment in data centers, for example, produce a significant amount of heat, which must be removed from interior spaces to maintain proper operation of such equipment. Cooling systems, such as those used in data centers, typically use wired temperature sensors for system control functions. Flexibility in correctly positioning wired temperature sensors and routing associated cabling during installation and commissioning for proper system control can be limited and can lead to increased thermal unit component oscillations, i.e., cooling systems can ramp up and down frequently. These oscillations can lead to increased energy usage, wear and tear on cooling system components, and an inability to maintain stable environmental conditions. There can also be limitations with regard to the quantity of wired temperature sensors. For example, wiring numerous wired temperature sensors can be impractical, such as due to space constraints, physical obstacles, etc. Additionally, one cooling system, or a component thereof, may not be able to readily use sensor data from a wired temperature sensor physically connected to another cooling system.

### SUMMARY

Applicant has created new and useful devices, systems and methods for cooling systems, such as those used in data centers. By utilizing wireless sensors, such as wireless temperature sensors, to control computer room air conditioning units, or other cooling systems, limitations of wired temperature sensors can be overcome. For example, more wireless sensors can be installed than wired sensors, which can provide for more accurate and distributed temperature measurements, as well as sensor redundancy.

In at least one example, a cooling system according to the disclosure can include a cooling unit for supplying cooling air, one or more enclosures that receive the cooling air from the cooling unit, a cooling air supply path for routing the cooling air from the cooling unit to the enclosure, one or more wireless sensors disposed in the cooling air supply path and in wireless communication with the cooling unit (directly or indirectly), or any combination thereof. In at least one example, the wireless sensors can be wireless temperature sensors, wireless humidity sensors, other wireless sensors, or any combination thereof. In at least one example, the cooling unit can utilize data from the wireless temperature sensor in supplying the cooling air, such as, for example, in determining a cooling air temperature.

In at least one example, the enclosure can include a plurality of computer equipment cabinets and/or the wireless temperature sensor can include a plurality of wireless temperature sensors. In at least one example, each wireless temperature sensor can be coupled to a different computer equipment cabinet. In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet.

In at least one example, all or any portion of the cooling unit can be located within the enclosure. In at least one example, all or any portion of the cooling unit can be external to the enclosure. In at least one example, the cooling unit can include a controller to determine a cooling air temperature using any or all of the wireless temperature sensors and/or control various aspects of the cooling unit, such as compressors, pumps, fans, valves, etc. For example, the controller can determine the cooling air temperature by averaging all of the properly functioning wireless temperature sensors. In at least one example, the controller can ignore faulty data from any of the wireless temperature sensors, when determining the cooling air temperature and/or controlling the cooling unit.

In at least one example, the wireless temperature sensor can include a plurality of wireless temperature sensors. In at least one example, each wireless temperature sensor can be coupled at different positions within the enclosure. In at least one example, the controller can determine the cooling air temperature using any combination of the wireless temperature sensors.

In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet. In at least one example, the controller can determine the cooling air temperature using any combination of the wireless temperature sensors.

In at least one example, a method according to the disclosure can improve a cooling system, such as those used in data centers. In at least one example, the cooling system can include a cooling unit for supplying cooling air, at least one enclosure configured to receive the cooling air from the cooling unit, a cooling air supply path configured to route the cooling air from the cooling unit to the enclosure, at least one wired temperature sensor disposed in the cooling air supply path and wired to the cooling unit, or any combination thereof. In at least one example, the method can include disposing at least one wireless temperature sensor in the cooling air supply path, configuring the cooling unit to communicate wirelessly with the wireless temperature sensor (directly or indirectly), configuring the cooling unit to determine a cooling air temperature using any combination of the wired temperature sensor and the wireless temperature sensor, or any combination thereof.

In at least one example, a cooling system can include a cooling unit for supplying cooling air, one or more enclosures that receive the cooling air from the cooling unit, a cooling air supply path for routing the cooling air from the cooling unit to the enclosure, a return air path for routing the cooling air from the enclosure to the cooling unit, one or more wired temperature sensors disposed in the cooling air supply path and wired to the cooling unit, one or more wireless temperature sensors disposed in the cooling air supply path and in wireless communication with the cooling unit (directly or indirectly), one or more wireless temperature sensors disposed in the return air path and wirelessly communicating with the cooling unit (directly or indirectly), or any combination thereof. In at least one example, the cooling unit can utilize data from any combination of the wired temperature sensors and the wireless temperature sensors in supplying the cooling air.

In at least one example, the enclosure can include a plurality of computer equipment cabinets. In at least one example, the wireless temperature sensor can include a plurality of wireless temperature sensors. In at least one example, each wireless temperature sensor can be coupled to a different computer equipment cabinet. In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet.

In at least one example, all or any portion of the cooling unit can be within the enclosure. In at least one example, all or any portion of the cooling unit can be external to the enclosure. In at least one example, the cooling unit can include a controller to determine a cooling air temperature using any or all of the wired temperature sensors and the wireless temperature sensors. In at least one example, the controller can ignore faulty data from any of the wired temperature sensors and the wireless temperature sensors when determining the cooling air temperature.

In at least one example, the wireless temperature sensor can include a plurality of wireless temperature sensors. In at least one example, each wireless temperature sensor can be coupled at different positions within the enclosure. In at least one example, the controller can determine the cooling air temperature using any combination of the wired temperature sensors and the wireless temperature sensors.

In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet. In at least one example, the controller can determine the cooling air temperature using any combination of the wired temperature sensors and the wireless temperature sensors.

### BRIEF DESCRIPTION OF THE DRAWINGS

FIG. 1 is a schematic view of one of many examples of a cooling system according to the disclosure.
FIG. 2 is a schematic view of another one of many examples of a cooling system according to the disclosure.
FIG. 3 is a schematic view of yet another one of many examples of a cooling system according to the disclosure.
FIG. 4 is a schematic view of still another one of many examples of a cooling system according to the disclosure.
FIG. 5 is a schematic view of another one of many examples of a cooling system according to the disclosure.
FIG. 6 is a perspective schematic view of another one of many examples of a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the examples for which patent protection is sought. Those skilled in the art will appreciate that not all features of a commercial example of the examples are described or shown for the sake of clarity and understanding. Persons of skill in this art will also appreciate that the development of an actual commercial example incorporating aspects of the present examples will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the examples disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the examples or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of flowchart illustration can be implemented by special purpose hardware-based systems that perform the specified functions or acts, or combinations of special purpose hardware and computer instructions.

Applicant has created new and useful devices, systems and methods for cooling systems, such as those used in data centers. By utilizing wireless temperature sensors to control computer room air conditioning units, or other cooling systems, limitations of wired temperature sensors can be overcome. For example, more wireless sensors can be installed than wired sensors, which can provide for more accurate and distributed temperature measurements, as well as sensor redundancy.

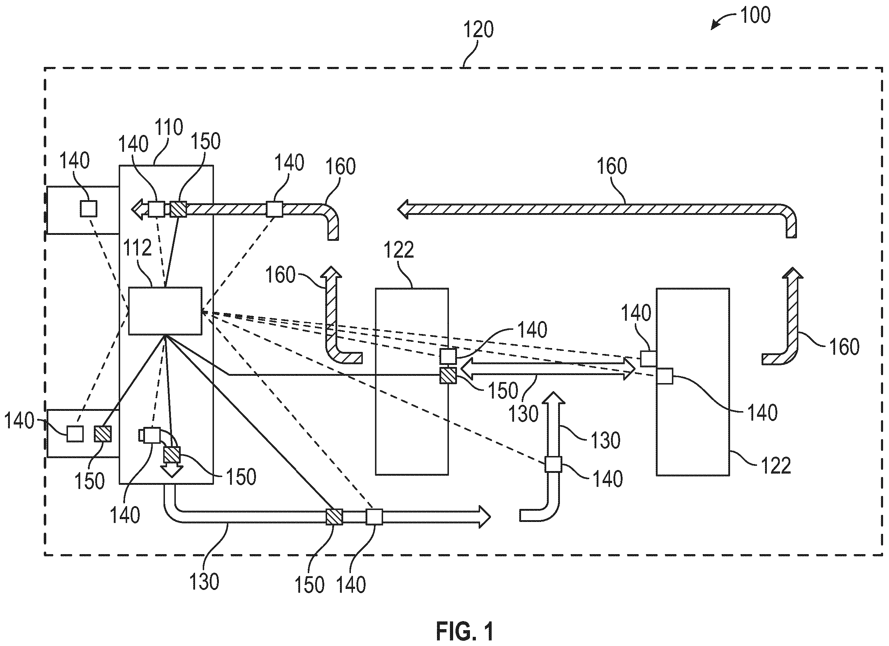

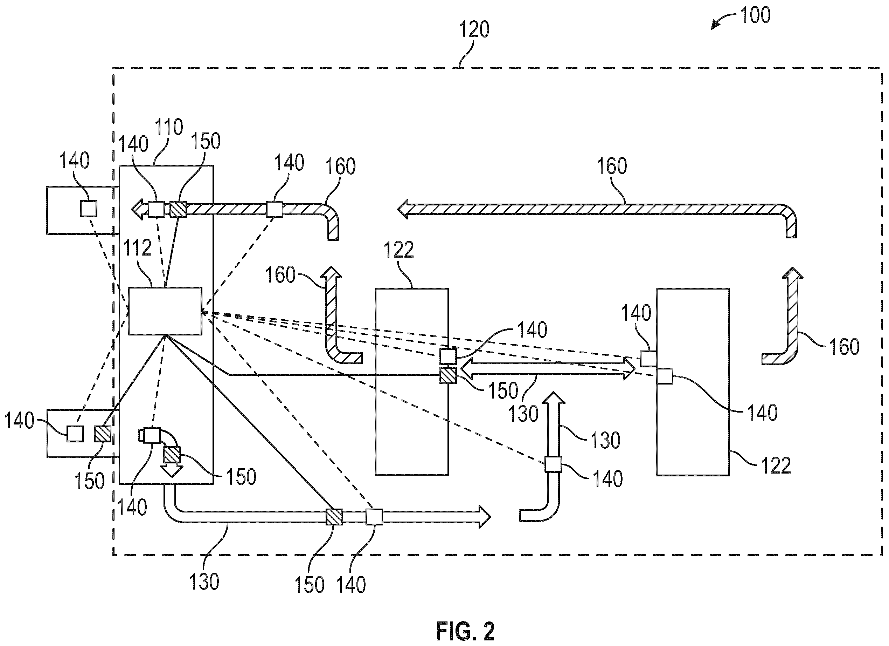

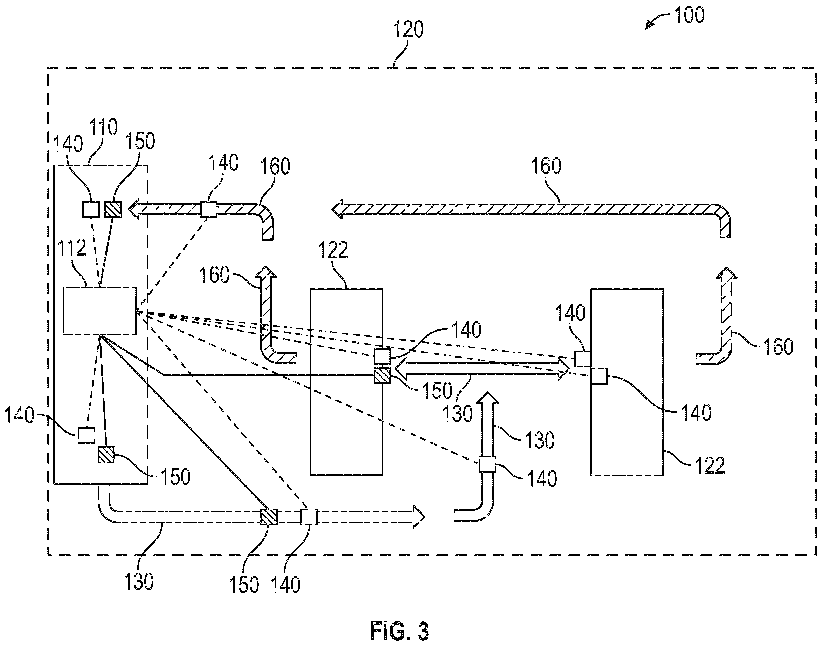

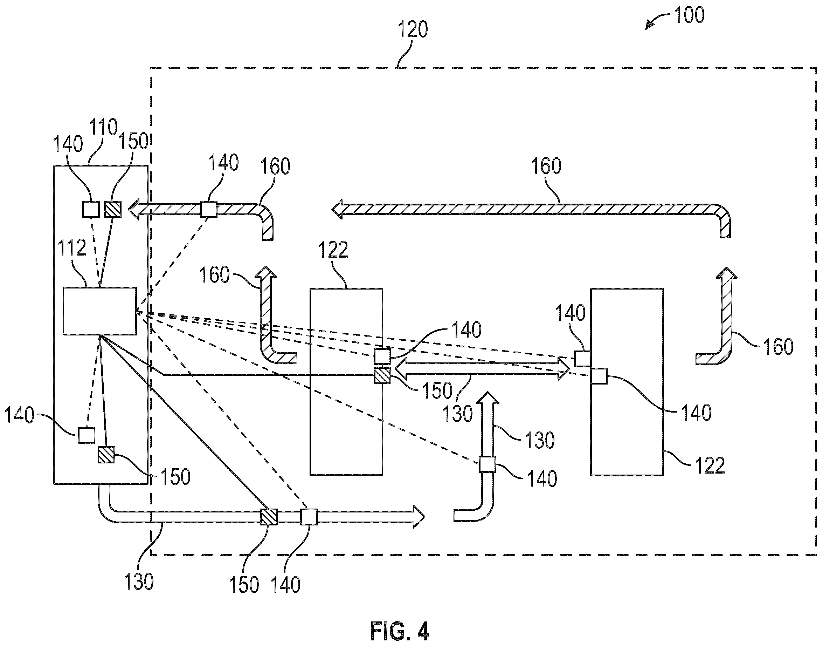

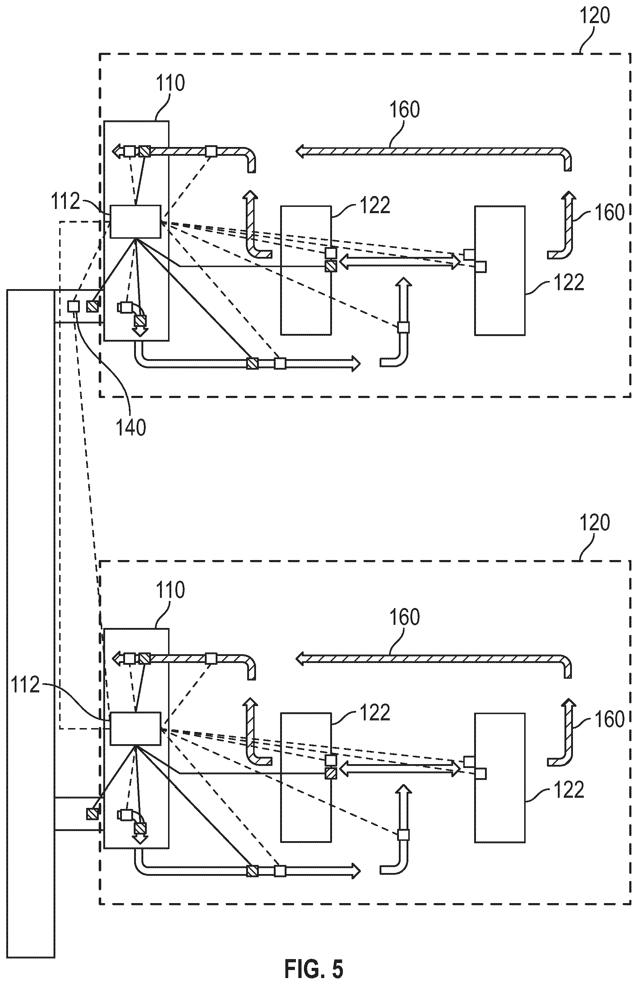

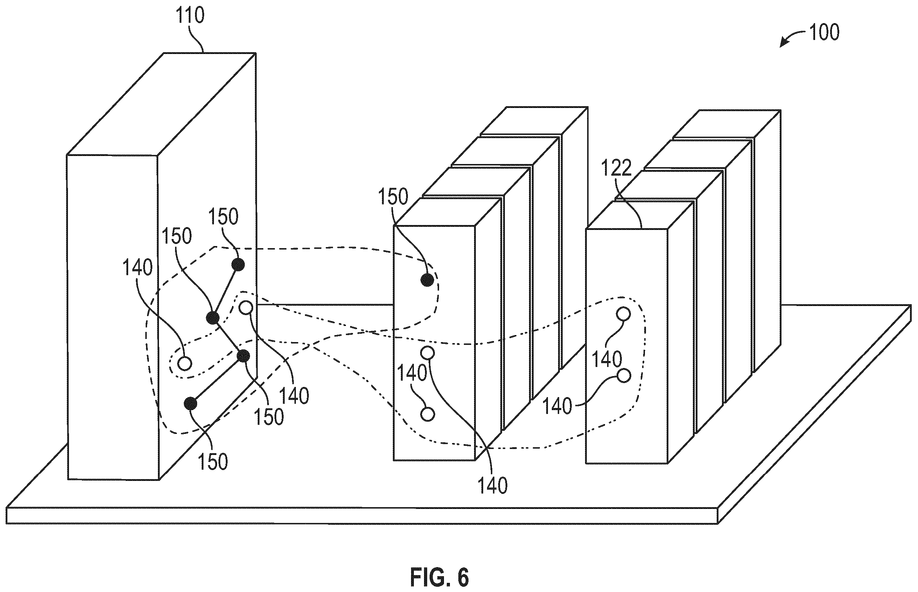

FIG. 1 is a schematic view of one of many examples of a cooling system according to the disclosure. FIG. 2 is a schematic view of another one of many examples of a cooling system according to the disclosure. FIG. 3 is a schematic view of yet another one of many examples of a cooling system according to the disclosure. FIG. 4 is a schematic view of still another one of many examples of a cooling system according to the disclosure. FIG. 5 is a schematic view of another one of many examples of a cooling system according to the disclosure. FIG. 6 is a perspective schematic view of another one of many examples of a cooling system according to the disclosure. FIGS. 1-6 are described in conjunction with one another.

In at least one example, a cooling system 100 according to the disclosure can include one or more cooling units 110 for supplying cooling air, one or more enclosures 120 that receive the cooling air from the cooling unit 110, one or more cooling air supply paths 130 for routing the cooling air from the cooling unit 110 to the enclosure 120, one or more wireless sensors 140 disposed in the cooling air supply path 130 and in wireless communication with the cooling unit 110 (directly or indirectly), or any combination thereof. In at least one example, the wireless sensors 140 can be wireless temperature sensors, wireless humidity sensors, other wireless sensors, or any combination thereof. In at least one example, the cooling unit 110 can utilize data from the wireless temperature sensor 140 in supplying the cooling air, such as, for example, in determining a cooling air temperature. In at least one example, the cooling air supply path 130 can exit the cooling unit 110 from the front, back, side, top bottom, or any combination thereof.

In at least one example, the wireless sensors 140 can be in direct wireless communication with the cooling unit 110 and/or indirect wireless communication with the cooling unit 110. In at least one example, one or more of the wireless sensors 140 can communicate with the cooling unit 110 through a partially wireless communications link and a partially wired communications link. In at least one example, one or more wireless sensors 140 can be in direct wireless communication with one or more wireless gateway devices and/or other network devices that are in wired communication with the cooling unit 110.

In at least one example, the enclosure 120 can include a plurality of computer equipment cabinets 122 and/or the wireless temperature sensor 140 can include a plurality of wireless temperature sensors 140. In at least one example, each wireless temperature sensor 140 can be coupled to a different computer equipment cabinet 122. In at least one example, the enclosure 120 can include a computer room 124, a first computer equipment cabinet 122 within the computer room 124, a second computer equipment cabinet 122 within the computer room 124, or any combination thereof. In at least one example, the wireless temperature sensor 140 can include a first wireless temperature sensor 140 coupled to the first cabinet 122 a second wireless temperature sensor 140 coupled to the second cabinet 122, a third wireless temperature sensor 140 coupled elsewhere in the computer room 124, a fourth wireless temperature sensor 140 coupled outside the computer room 124, or any combination thereof.

In at least one example, all or any portion of the cooling unit 110 can be located within the enclosure 120. In at least one example, all or any portion of the cooling unit 110 can be external to the enclosure 120. In at least one example, the cooling unit 110 can include a controller 112 to determine a cooling air temperature using any or all of the wireless temperature sensors 140 and/or control various aspects of the cooling unit, such as compressors, pumps, fans, valves, etc. For example, the controller 112 can determine the cooling air temperature by averaging all of the properly functioning wireless temperature sensors 140. In at least one example, the controller 112 can ignore faulty data from any of the wireless temperature sensors 140, when determining the cooling air temperature and/or controlling the cooling unit 110.

In at least one example, the wireless temperature sensor 140 can include a plurality of wireless temperature sensors 140. In at least one example, each wireless temperature sensor 140 can be coupled at different positions within the enclosure 120. In at least one example, the controller 112 can determine the cooling air temperature using any combination of the wireless temperature sensors 140.

In at least one example, the controller 112 can determine the cooling air temperature using one or more wireless temperature sensors 140 associated with another cooling unit 110. In at least one example, the controller 112 of one cooling unit 110 can communicate with the controller 112 of another cooling unit 110, and share data from one or more wireless temperature sensors 140 over that communication. In at least one example, the controller 112 of one cooling unit 110 can communicate with one or more wireless temperature sensors 140 associated with another cooling unit 110 directly. In at least one example, one or more wireless sensors 140 can be in communication with a network over which data is communicated and/or shared among one or more cooling units 110.

In at least one example, the enclosure 120 can include a computer room 124, a first computer equipment cabinet 122 within the computer room 124, a second computer equipment cabinet 122 within the computer room 124, or any combination thereof. In at least one example, the wireless temperature sensor 140 can include a first wireless temperature sensor 140 coupled to the first cabinet 122 and/or a second wireless temperature sensor 140 coupled to the second cabinet 122. In at least one example, the controller 110 can determine the cooling air temperature using any combination of the wireless temperature sensors 140.

In at least one example, a method according to the disclosure can improve a cooling system 100, such as those used in data centers. In at least one example, the cooling system 100 can include a cooling unit 110 for supplying cooling air, at least one enclosure 120 configured to receive the cooling air from the cooling unit 110, a cooling air supply path 130 configured to route the cooling air from the cooling unit 110 to the enclosure 120, one or more wired temperature sensors 150 disposed in the cooling air supply path 130 and wired to the cooling unit 110, or any combination thereof. In at least one example, the method can include disposing one or more wireless temperature sensors 140 in the cooling air supply path 130, configuring the cooling unit 110 to communicate wirelessly with the wireless temperature sensor 140 (directly or indirectly), configuring the cooling unit 110 to determine a cooling air temperature using any combination of the wired temperature sensor 150 and the wireless temperature sensor 140, or any combination thereof.

In at least one example, a cooling system 100 can include a cooling unit 110 for supplying cooling air, one or more enclosures 120 that receive the cooling air from the cooling unit, one or more cooling air supply paths 130 for routing the cooling air from the cooling unit 110 to the enclosure 120, on or more return air paths 160 for routing the cooling air from the enclosure 120 to the cooling unit 110, one or more wired temperature sensors 150 disposed in the cooling air supply path 130 and wired to the cooling unit 110, one or more wireless temperature sensors 140 disposed in the cooling air supply path 130 and in wireless communication with the cooling unit 110 (directly or indirectly), one or more wireless temperature sensors 140 disposed in the return air path 160 and in wireless communication with the cooling unit 110 (directly or indirectly), or any combination thereof. In at least one example, the cooling unit 110 can utilize data from any combination of the wired temperature sensors 150 and the wireless temperature sensors 140 in supplying the cooling air. In at least one example, the return air path 160 can enter the cooling unit 110 from the front, back, side, top, bottom, or any combination thereof.

In at least one example, the enclosure 120 can include a plurality of computer equipment cabinets 122. In at least one example, the wireless temperature sensor 140 can include a plurality of wireless temperature sensors 140. In at least one example, each wireless temperature sensor 140 can be coupled to a different computer equipment cabinet 122. In at least one example, the enclosure 120 can include a computer room 124, a first computer equipment cabinet 122 within the computer room 124, a second computer equipment cabinet 122 within the computer room 124, or any combination thereof. In at least one example, the wireless temperature sensor 140 can include a first wireless temperature sensor 140 coupled to the first cabinet 122 and/or a second wireless temperature sensor 140 coupled to the second cabinet 122. In at least one example, the wireless temperature sensor 140 can be coupled within the cooling air supply paths 130, within the computer room 124, outside the computer room 124, within the computer equipment cabinet 122, outside the computer equipment cabinet 122, or any combination thereof.

In at least one example, all or any portion of the cooling unit 110 can be within the enclosure 120. In at least one example, all or any portion of the cooling unit 110 can be external to the enclosure 120. In at least one example, the cooling unit 110 can include a controller 112 to determine a cooling air temperature using any combination of the wired temperature sensors 150 and the wireless temperature sensors 140. In at least one example, the controller 112 can ignore faulty data from any of the wired temperature sensors 150 and the wireless temperature sensors 140 when determining the cooling air temperature.

In at least one example, the wireless temperature sensor 140 can include a plurality of wireless temperature sensors 140. In at least one example, each wireless temperature sensor 140 can be coupled at different positions within the enclosure 120. In at least one example, the controller 112 can determine the cooling air temperature using any combination of the wired temperature sensors 150 and the wireless temperature sensors 140.

In at least one example, the enclosure 120 can include a computer room 124, a first computer equipment cabinet 122 within the computer room 124, a second computer equipment cabinet 122 within the computer room 124, or any combination thereof. In at least one example, the wireless temperature sensor 140 can include a first wireless temperature sensor 140 coupled to the first cabinet 122 and/or a second wireless temperature sensor 140 coupled to the second cabinet 122. In at least one example, the controller 112 can determine the cooling air temperature using any combination of the wired temperature sensors 150 and the wireless temperature sensors 140.

In at least one example, a cooling system can include a cooling unit for supplying cooling air, one or more enclosures that receive the cooling air from the cooling unit, a cooling air supply path for routing the cooling air from the cooling unit to the enclosure, one or more wireless sensors disposed in the cooling air supply path and in wireless communication with the cooling unit (directly or indirectly), or any combination thereof. In at least one example, the wireless sensors can be wireless temperature sensors, wireless humidity sensors, other wireless sensors, or any combination thereof. In at least one example, the cooling unit can utilize data from the wireless temperature sensor in supplying the cooling air, such as, for example, in determining a cooling air temperature.

In at least one example, the enclosure can include a plurality of computer equipment cabinets and/or the wireless temperature sensor can include a plurality of wireless temperature sensors. In at least one example, each wireless temperature sensor can be coupled to a different computer equipment cabinet. In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet.

In at least one example, all or any portion of the cooling unit can be located within the enclosure. In at least one example, all or any portion of the cooling unit can be external to the enclosure. In at least one example, the cooling unit can include a controller to determine a cooling air temperature using any or all of the wireless temperature sensors and/or control various aspects of the cooling unit, such as compressors, pumps, fans, valves, etc. For example, the controller can determine the cooling air temperature by averaging all of the properly functioning wireless temperature sensors. In at least one example, the controller can ignore faulty data from any of the wireless temperature sensors, when determining the cooling air temperature and/or controlling the cooling unit.

In at least one example, the wireless temperature sensor can include a plurality of wireless temperature sensors. In at least one example, each wireless temperature sensor can be coupled at different positions within the enclosure. In at least one example, the controller can determine the cooling air temperature using any combination of the wireless temperature sensors.

In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet. In at least one example, the controller can determine the cooling air temperature using any combination of the wireless temperature sensors.

In at least one example, a method according to the disclosure can improve a cooling system, such as those used in data centers. In at least one example, the cooling system can include a cooling unit for supplying cooling air, at least one enclosure configured to receive the cooling air from the cooling unit, a cooling air supply path configured to route the cooling air from the cooling unit to the enclosure, at least one wired temperature sensor disposed in the cooling air supply path and wired to the cooling unit, or any combination thereof. In at least one example, the method can include disposing at least one wireless temperature sensor in the cooling air supply path, configuring the cooling unit to communicate wirelessly with the wireless temperature sensor (directly or indirectly), configuring the cooling unit to determine a cooling air temperature using any combination of the wired temperature sensor and the wireless temperature sensor, or any combination thereof.

In at least one example, a cooling system can include a cooling unit for supplying cooling air, one or more enclosures that receive the cooling air from the cooling unit, a cooling air supply path for routing the cooling air from the cooling unit to the enclosure, a return air path for routing the cooling air from the enclosure to the cooling unit, one or more wired temperature sensors disposed in the cooling air supply path and wired to the cooling unit, one or more wireless temperature sensors disposed in the cooling air supply path and in wireless communication with the cooling unit (directly or indirectly), one or more wireless temperature sensors disposed in the return air path and in wireless communication with the cooling unit (directly or indirectly), or any combination thereof. In at least one example, the cooling unit can utilize data from any combination of the wired temperature sensors and the wireless temperature sensors in supplying the cooling air.

In at least one example, the enclosure can include a plurality of computer equipment cabinets. In at least one example, the wireless temperature sensor can include a plurality of wireless temperature sensors. In at least one example, each wireless temperature sensor can be coupled to a different computer equipment cabinet. In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet.

In at least one example, all or any portion of the cooling unit can be within the enclosure. In at least one example, all or any portion of the cooling unit can be external to the enclosure. In at least one example, the cooling unit can include a controller to determine a cooling air temperature using any or all of the wired temperature sensors and the wireless temperature sensors. In at least one example, the controller can ignore faulty data from any of the wired temperature sensors and the wireless temperature sensors when determining the cooling air temperature.

In at least one example, the wireless temperature sensor can include a plurality of wireless temperature sensors. In at least one example, each wireless temperature sensor can be coupled at different positions within the enclosure. In at least one example, the controller can determine the cooling air temperature using any combination of the wired temperature sensors and the wireless temperature sensors.

In at least one example, the enclosure can include a computer room, a first computer equipment cabinet within the computer room, a second computer equipment cabinet within the computer room, or any combination thereof. In at least one example, the wireless temperature sensor can include a first wireless temperature sensor coupled to the first cabinet and/or a second wireless temperature sensor coupled to the second cabinet. In at least one example, the controller can determine the cooling air temperature using any combination of the wired temperature sensors and the wireless temperature sensors.

Other and further examples utilizing one or more aspects of the disclosure can be devised without departing from the Applicant's disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. A cooling system comprising:
   a cooling unit configured to supply cooling air;
   at least one enclosure configured to receive the cooling air from the cooling unit;
   a cooling air supply path configured to route the cooling air from the cooling unit to the at least one enclosure; and
   at least one wireless sensor disposed in the cooling air supply path and in wireless communication with the cooling unit,
   wherein the cooling unit is configured to utilize data from the at least one wireless sensor in supplying the cooling air.
2. The cooling system of clause 1, wherein the at least one enclosure includes a plurality of computer equipment cabinets, wherein the at least one wireless sensor includes a plurality of wireless temperature sensors, and wherein each wireless temperature sensor is coupled to a different computer equipment cabinet.
3. The cooling system of clause 1 or 2, wherein the at least one enclosure includes a computer room, a first computer equipment cabinet within the computer room, and a second computer equipment cabinet within the computer room, and wherein the at least one wireless sensor includes a first wireless temperature sensor coupled to the first cabinet and a second wireless temperature sensor coupled to the second cabinet.
4. The cooling system of any one of the preceding clauses, wherein at least a portion of the cooling unit is within the enclosure.
5. The cooling system of any one of the preceding clauses, wherein at least a portion of the cooling unit is external to the enclosure.
6. The cooling system of any one of the preceding clauses, wherein the cooling unit includes a controller configured to determine a cooling air temperature using the at least one wireless sensor.
7. The cooling system of clause 6, wherein the controller is configured to ignore faulty data from the at least one wireless sensor when determining the cooling air temperature.
8. The cooling system of clause 6, wherein the at least one wireless sensor includes a plurality of wireless temperature sensors, wherein each wireless temperature sensor is disposed at a different position within the enclosure, and wherein the controller is configured to determine the cooling air temperature using the wireless temperature sensors.
9. The cooling system of clause 6, wherein the at least one enclosure includes a computer room, a first computer equipment cabinet within the computer room, and a second computer equipment cabinet within the computer room, wherein the at least one wireless sensor includes a first wireless temperature sensor coupled to the first cabinet and a second wireless temperature sensor coupled to the second cabinet, and wherein the controller is configured to determine the cooling air temperature using both wireless temperature sensors.
10. A method of improving a cooling system having a cooling unit configured to supply cooling air, at least one enclosure configured to receive the cooling air from the cooling unit, a cooling air supply path configured to route the cooling air from the cooling unit to the at least one enclosure, and at least one wired temperature sensor disposed in the cooling air supply path and wired to the cooling unit, the method comprising:
   disposing at least one wireless temperature sensor in the cooling air supply path; and
   configuring the cooling unit to:
      communicate wirelessly with the at least one wireless temperature sensor, and
      determine a cooling air temperature using both the at least one wired temperature sensor and the at least one wireless temperature sensor.
11. A cooling system comprising:
   a cooling unit configured to supply cooling air;
   at least one enclosure configured to receive the cooling air from the cooling unit;
   a cooling air supply path configured to route the cooling air from the cooling unit to the at least one enclosure;
   a return air path configured to route the cooling air from the at least one enclosure to the cooling unit;
   at least one wired temperature sensor disposed in the cooling air supply path and wired to the cooling unit; and
   at least one wireless temperature sensor disposed in the cooling air supply path and in wireless communication with the cooling unit,
   wherein the cooling unit is configured to utilize data from both the at least one wired temperature sensor and the at least one wireless temperature sensor in supplying the cooling air.
12. The cooling system of clause 11, wherein the at least one enclosure includes a plurality of computer equipment cabinets, wherein the at least one wireless temperature sensor includes a plurality of wireless temperature sensors, and wherein each wireless temperature sensor is coupled to a different computer equipment cabinet.
13. The cooling system of clause 11 or 12, wherein the at least one enclosure includes a computer room, a first computer equipment cabinet within the computer room, and a second computer equipment cabinet within the computer room and wherein the at least one wireless temperature sensor includes a first wireless temperature sensor coupled to the first cabinet and a second wireless temperature sensor coupled to the second cabinet.
14. The cooling system of any one of clauses 11-13, wherein at least a portion of the cooling unit is within the enclosure.
15. The cooling system of any one of clauses 11-14, wherein at least a portion of the cooling unit is external to the enclosure.
16. The cooling system of any one of clauses 11-15, wherein the cooling unit includes a controller configured to determine a cooling air temperature using both the at least one wired temperature sensor and the at least one wireless temperature sensor.
17. The cooling system of clause 16, wherein the controller is configured to ignore faulty data from any of the at least one wired temperature sensor and the at least one wireless temperature sensor when determining the cooling air temperature.
18. The cooling system of clause 16, wherein the at least one wireless temperature sensor includes a plurality of wireless temperature sensors, wherein each wireless temperature sensor is disposed at a different position within the enclosure, and wherein the controller is configured to determine the cooling air temperature using the at least one wired temperature sensor and the plurality of wireless temperature sensors.
19. The cooling system of clause 16, wherein the at least one enclosure includes a computer room, a first computer equipment cabinet within the computer room, and a second computer equipment cabinet within the computer room, wherein the at least one wireless temperature sensor includes a first wireless temperature sensor coupled to the first cabinet and a second wireless temperature sensor coupled to the second cabinet, and wherein the controller is configured to determine the cooling air temperature using the at least one wired temperature sensor and both wireless temperature sensors.
20. The cooling system of any one of clauses 11-19, further including at least one wireless temperature sensor disposed in the return air path and in wireless communication with the cooling unit.
21. The cooling system of any one of the preceding clauses, wherein the at least one wireless sensor is in wireless communication with one or more communication devices disposed in communication with the cooling unit.
22. The cooling system of clause 21, wherein at least one of the one or more communication devices is in wired communication with the cooling unit.
23. The cooling system of any one of the preceding clauses, wherein the at least one wireless sensor is configured to sense at least one of temperature or humidity.
24. The cooling system of any one of clauses 11-23, wherein at least one of the at least one wired temperature sensor or the at least one wireless temperature sensor is a combined temperature and humidity sensor.
25. A method as shown and/or described herein.
26. A system as shown and/or described herein.

The examples have been described in the context of preferred and other examples and not every example of the examples has been described. Obvious modifications and alterations to the described examples are available to those of ordinary skill in the art having the benefits of the present disclosure. The disclosed and undisclosed examples are not intended to limit or restrict the scope or applicability of the examples conceived of by the Applicant, but rather, in conformity with the patent laws, Applicant intends to fully protect all such modifications and improvements that come within the scope or range of equivalents of the following claims.

## Claims

1. A cooling system comprising:
a cooling unit configured to supply cooling air;
at least one enclosure configured to receive the cooling air from the cooling unit;
a cooling air supply path configured to route the cooling air from the cooling unit to the at least one enclosure; and
at least one wireless sensor disposed in the cooling air supply path and in wireless communication with the cooling unit;
wherein the cooling unit is configured to utilize data from the at least one wireless sensor in supplying the cooling air.

2. The cooling system of claim 1, wherein the at least one enclosure includes a plurality of computer equipment cabinets, wherein the at least one wireless sensor includes a plurality of wireless temperature sensors, and wherein each wireless temperature sensor is coupled to a different computer equipment cabinet.

3. The cooling system of claim 1, wherein the at least one enclosure includes a computer room, a first computer equipment cabinet within the computer room, and a second computer equipment cabinet within the computer room, and wherein the at least one wireless sensor includes a first wireless temperature sensor coupled to the first cabinet and a second wireless temperature sensor coupled to the second cabinet.

4. The cooling system of any one of the preceding claims, wherein at least a portion of the cooling unit is within the enclosure; or optionally wherein at least a portion of the cooling unit is external to the enclosure.

5. The cooling system of any one of the preceding claims, wherein the cooling unit includes a controller configured to determine a cooling air temperature using the at least one wireless sensor.

6. The cooling system of claim 5, wherein the controller is configured to ignore faulty data from the at least one wireless sensor when determining the cooling air temperature.

7. The cooling system of claim 5, wherein the at least one wireless sensor includes a plurality of wireless temperature sensors, wherein each wireless temperature sensor is disposed at a different position within the enclosure, and wherein the controller is configured to determine the cooling air temperature using the wireless temperature sensors.

8. The cooling system of claim 5, wherein the at least one enclosure includes a computer room, a first computer equipment cabinet within the computer room, and a second computer equipment cabinet within the computer room, wherein the at least one wireless sensor includes a first wireless temperature sensor coupled to the first cabinet and a second wireless temperature sensor coupled to the second cabinet, and wherein the controller is configured to determine the cooling air temperature using both wireless temperature sensors.

9. The cooling system of claim 1, further comprising:
a return air path configured to route the cooling air from the at least one enclosure to the cooling unit;
at least one wired temperature sensor disposed in the cooling air supply path and wired to the cooling unit; and
wherein the cooling unit is configured to utilize data from both the at least one wired temperature sensor and the at least one wireless temperature sensor in supplying the cooling air.

10. The cooling system of claim 9, wherein the at least one enclosure includes a plurality of computer equipment cabinets, wherein the at least one wireless temperature sensor includes a plurality of wireless temperature sensors, and wherein each wireless temperature sensor is coupled to a different computer equipment cabinet.

11. The cooling system of claim 9, wherein the at least one enclosure includes a computer room, a first computer equipment cabinet within the computer room, and a second computer equipment cabinet within the computer room and wherein the at least one wireless temperature sensor includes a first wireless temperature sensor coupled to the first cabinet and a second wireless temperature sensor coupled to the second cabinet.

12. The cooling system of any one of claims 9-11, wherein at least a portion of the cooling unit is within the enclosure; or optionally
wherein at least a portion of the cooling unit is external to the enclosure.

13. The cooling system of claim 9, wherein the cooling unit includes a controller configured to determine a cooling air temperature using both the at least one wired temperature sensor and the at least one wireless temperature sensor; or optionally
wherein the controller is configured to ignore faulty data from any of the at least one wired temperature sensor and the at least one wireless temperature sensor when determining the cooling air temperature.

14. The cooling system of claim 19, wherein the at least one wireless temperature sensor includes a plurality of wireless temperature sensors, wherein each wireless temperature sensor is disposed at a different position within the enclosure, and wherein the controller is configured to determine the cooling air temperature using the at least one wired temperature sensor and the plurality of wireless temperature sensors; or optionally
wherein the at least one enclosure includes a computer room, a first computer equipment cabinet within the computer room, and a second computer equipment cabinet within the computer room, wherein the at least one wireless temperature sensor includes a first wireless temperature sensor coupled to the first cabinet and a second wireless temperature sensor coupled to the second cabinet, and wherein the controller is configured to determine the cooling air temperature using the at least one wired temperature sensor and both wireless temperature sensors.

15. The cooling system of claim 9, further comprising at least one wireless temperature sensor disposed in the return air path and in wireless communication with the cooling unit; or optionally
wherein at least one of the at least one wired temperature sensor or the at least one wireless temperature sensor is a combined temperature and humidity sensor.
